# FASCICULE DE BREVET EUROPEEN

(11) **EP 3 520 147 B1**
(45) Date de publication et mention de la délivrance du brevet: **12.08.2020**
(21) Numéro de dépôt: 17787481.5
(22) Date de dépôt: 27.09.2017
(51) Int. Cl.: H01L 31/048

(54) **PROCEDE D'ENCAPSULATION DE PANNEAUX PHOTOVOLTAÏQUES EN UTILISANT DES MATERIAUX PRE-IMPREGNES**
VERFAHREN ZUR VERKAPSELUNG VON FOTOVOLTAIKTAFELN MITHILFE VORIMPRÄGNIERTER MATERIALIEN
PROCESS FOR ENCAPSULATING PHOTOVOLTAIC PANELS USING PREIMPREGNATED MATERIALS

(30) Priorité: 29.09.2016 FR 1659368
(43) Date de publication de la demande: 07.08.2019
(73) Titulaire: Total Solar International, 92400 Courbevoie (FR)
(72) Inventeur: DINELLI, Raphaël, 85340 Olonne-Sur-Mer (FR)
(74) Mandataire: Vidon Brevets & Stratégie
(86) Numéro de dépôt international: PCT/FR2017/052616
(87) Numéro de publication internationale: WO 2018/060611

(56) Documents cités:
- FR-A1- 2 934 418
- US-A- 4 147 560
- US-A1- 2010 006 141
- US-B1- 6 320 115
- US-B1- 6 331 673

## Description

### 1. DOMAINE DE L'INVENTION

L'invention concerne un procédé de fabrication de panneaux solaires dotés d'une pluralité de couches minces encapsulées dans de la résine et le panneau issu du procédé de fabrication. La présente invention concerne plus particulièrement le fait que le procédé utilise des couches de polymères et de tissu pré-imprégné de résine époxy, placées de chaque coté de la couche constituée par les cellules photovoltaïques.

### 2. ARRIÈRE-PLAN TECHNOLOGIQUE

Du fait de la réduction du stock des énergies fossiles et de l'augmentation de la pollution générée par la consommation de ces matériaux, on se tourne de plus en plus vers des ressources naturelles et la consommation d'énergie dans une logique de développement durable. Cette tendance conduit naturellement à privilégier les énergies naturelles, telles que l'énergie solaire. Il est désormais classique d'installer des panneaux photovoltaïques notamment sur les toitures des entreprises, des bâtiments publics, ou simplement sur les toits des habitations particulières pour fournir de l'énergie aux équipements de l'habitation en question, ou pour revendre cette énergie à un fournisseur.

Les panneaux solaires doivent être suffisamment fins en épaisseur et léger pour limiter leurs poids et leurs encombrements, ce qui permet par exemple de les embarquer dans un véhicule. De façon à s'adapter à des endroits très divers et de fonctionner en étant soumis à des agressions climatiques, des vibrations et des contraintes mécaniques en général, les panneaux doivent posséder une structure suffisamment résistante tout en étant fin. Pour résoudre ces contraintes de structure, il est connu d'encapsuler des panneaux de cellules photovoltaïques dans un enrobant tel que des polymères et une plaque de verre au détriment du poids.

Les cellules photovoltaïques doivent être protégées tant d'un point de vue mécanique que pour les protéger des agressions extérieures telles que de l'air et de l'eau. En outre, la forme du support peut varier de façon sensible, et notamment présenter une surface de réception incurvée. Il est donc nécessaire de pouvoir adapter la forme du panneau photovoltaïque à celle du support. De façon générale, lors de la conception et de la fabrication d'un panneau photovoltaïque encapsulé, on cherche donc à assurer au panneau encapsulé l'ensemble des propriétés suivantes :
- épaisseur minimale ;
- légèreté ;
- déformabilité ;
- translucidité ;
- étanchéité ;
- fiabilité.

La demande de brevet FR2 934 418 déposée par la demanderesse décrit un procédé d'encapsulation d'un panneau de cellules photovoltaïques par un procédé d'injection de résine sous infusion sur des tissus de fibre de verre. Ce document enseigne une technique d'encapsulation de panneaux de cellules photovoltaïques qui préserve la possibilité d'obtenir un panneau encapsulé déformable. Plus précisément, la demande antérieure citée ci-dessus, comporte notamment des étapes d'application de plusieurs tissus de fibre de verre dans un moule, et d'injection d'une résine sous infusion, ladite étape d'injection étant accompagnée d'une étape de dégazage de ladite résine, conduisant à l'obtention d'un panneau encapsulé.

Bien qu'ayant produit des résultats tout à fait encourageants, le procédé ainsi décrit possède plusieurs inconvénients. La méthode d'infusion de résine ne donne pas une qualité structurelle fiable dans le temps avec des couches fines de matières. En effet les conditions climatiques finissent par décoller les matériaux par délamination. De plus, la résine époxy jaunit avec le temps sous l'action prolongée des rayons du soleil et des intempéries, et le panneau perd en performance et ne présente plus un bel aspect. La mise en œuvre du procédé d'injection de résine époxy est assez complexe car il requiert du savoir-faire et beaucoup de temps pour la mise en place. Enfin, le procédé génère une quantité importante de matières consommables perdues, transformées en déchets, tuyaux, film plastique...

De façon générale, un panneau solaire est composé des cellules photovoltaïques montées en série pour augmenter la tension du module. Les connectiques positives et négatives transportent le courant vers le système de régulation. Quand un ombrage affecte le module la tension nominale transmise à la régulation s'effondre et met le module en court-circuit. Le courant produit par les cellules non ombragées passe par les cellules ombragées et risque de mettre celles-ci en surtension. Pour éviter ce phénomène, les cellules mises en série sont reliées à des diodes dites « bypass » qui bloquent le courant des cellules ombragées. Ces diodes étant volumineuses, elles sont installées dans une boite de jonction fixées à la surface du panneau. La présence d'une multitude de boîtes de jonction présente de nombreux inconvénients lorsqu'elles sont mises en face avant du panneau. La présence de ces boîtes réduit la surface utile du panneau et donc son rendement global. La connectique pour relier ces diodes et la surface de la boite de jonction augmente la surface au détriment de celle utile des cellules. De plus, les diodes dégagent de la chaleur quand elles fonctionnent et imposent un certain volume à la boite de jonction. Enfin, la ventilation nécessaire est assurée par une ouverture non étanche à l'humidité. Avec le temps l'humidité corrode les connectiques et crée des faux contacts qui peuvent causer des départs de feu.

L'invention a notamment pour objectif de palier à au moins l'un de ces inconvénients de l'art antérieur. Plus précisément, un objectif principal réside dans le fait de faciliter la fabrication, de pouvoir garantir une bonne tenue des matériaux, et d'améliorer la fiabilité des panneaux en limitant les pertes de rendement du au vieillissement.

### 3. EXPOSÉ DE L'INVENTION

Dans un mode de réalisation particulier de l'invention, il est proposé un procédé de fabrication d'un panneau de cellules photovoltaïques, comportant une étape de cuisson d'un empilement d'une pluralité de couches comprenant des matériaux différents. La pluralité de couches comporte les couches suivantes :
- une couche avant translucide en polymère.
- au moins deux couches de tissu sec de fibres de verre,
- au moins deux couches de tissu de fibres de verre pré-imprégné de résine époxy,
- une couche de cellules photovoltaïques,
- une couche arrière en polymère.

Le nouveau procédé permet de corriger les défauts de la première invention décrite dans la demande FR2 934 418. En effet l'utilisation de tissus de fibre de verre pré-imprégné de résine époxyde associés à des films polymères permet de garantir dans le temps sous l'effet des conditions climatiques une excellente tenue mécanique du panneau. Les films polymères utilisés permettent au panneau de ne pas jaunir sous l'influence des rayons UV et/ou de la température, et/ou de l'humidité. L'utilisation de ces matériaux autorise l'industrialisation, comparée à la solution sous infusion décrite dans l'art antérieur. De plus, l'utilisation de ces matériaux procure une flexibilité accrue et une grande souplesse d'utilisation pour permettre aux panneaux ainsi fabriqués de se fixer sur tout type de support.

La fabrication du module est réalisable sur une chaîne de fabrication standard de panneaux solaires, en l'adaptant aux nouveaux matériaux utilisés et aux nouvelles étapes du processus de fabrication. Ces produits sont considérés comme des laminés secs que l'on peut poser successivement sur un marbre pour construire le module.

Selon un premier mode de réalisation, l'empilement consiste à empiler les couches ci-dessous dans cet ordre :
- la couche translucide en polymère se présentant en avant du panneau,
- une couche de tissu sec en fibres de verre,
- une couche de tissu de fibre de verre pré-imprégné de résine époxy,
- la couche des cellules photovoltaïques,
- une seconde couche de tissu sec en fibres de verre,
- une seconde couche de tissu de fibre de verre pré-imprégné de résine époxy,
- la couche en arrière du panneau en polymère.

De cette manière, la résine pré-imprégnant les tissus se répand mieux dans l'empilement et assure une meilleure solidarisation des couches après la cuisson.

Selon un autre mode de réalisation, la couche translucide en polymère empilée en premier se trouve au contact d'un support tel qu'un marbre d'encapsulation sur laquelle s'effectue l'étape de cuisson. De cette manière, la couche sur le dessus du panneau a un aspect lisse et sans aspérité, c'est à dire celui imprimé par le marbre d'encapsulation.

Selon un autre mode de réalisation, l'étape de cuisson commence par une étape préalable de mise sous vide de l'empilement qui peut s'effectuer par exemple en appliquant un film de mise sous vide sur l'empilement et en aspirant l'air sous le film à l'aide d'une pompe à vide. De cette manière, les couches sont maintenues sous pression et immobiles lors de la cuisson et les gaz présents avant cette étape ou générés au cours de cette étape sont facilement évacués à l'extérieur de l'empilement.

Selon un autre mode de réalisation, l'étape d'empilement des couches consiste à appliquer des couches de tissu sec de dimensions plus grandes que celles d'au moins la couche des cellules photovoltaïques, le procédé comporte en outre une étape de finition consistant notamment à détourer le panneau ainsi réalisé. De cette manière, l'aspiration des gaz par les cotés de l'empilement est facilité et chaque couche encapsulée possède la même dimension.

Selon un autre mode de réalisation, l'étape de cuisson consiste à maintenir un premier niveau de température pendant une durée déterminée et un second niveau de température dont la valeur est supérieure à la première pendant une seconde durée déterminée, et à maintenir l'empilement sans le bouger après cuisson pendant une troisième durée déterminée. De cette manière, la polymérisation de la résine époxy pré-imprégnant les tissus s'effectue de façon optimale.

Selon un autre mode de réalisation, la cuisson sous vide de l'empilement s'effectue dans un laminateur. De cette manière, la cuisson peut être automatisée.

Selon un autre mode de réalisation, préalablement à l'étape d'empilement des couches, le procédé comporte une étape de réalisation de la couche de cellules photovoltaïques comportant la connexion de lignes de cellules mises en série, par exemple, les dites lignes étant parfois connectées entre elles par des transistors à effet de champ qui sont encapsulés dans le panneau à l'issue de l'étape de cuisson. De cette manière, les transistors sont intégrés dans l'empilement évitant ainsi l'utilisation de boites de jonction, et la surface utile des panneaux est ainsi augmentée.

Selon un autre mode de réalisation, le procédé de fabrication comporte une étape de mise en place de connecteurs électriquement reliés à des lignes collectrices d'électricité reliées aux cellules et sortant de l'empilement, les connecteurs étant capotés par des boîtiers remplis de silicone. De cette manière, la réalisation des panneaux est plus rapide et comporte moins d'éléments à monter.

Selon un autre aspect, l'invention concerne un panneau de cellules photovoltaïques comportant une couche de cellules photovoltaïques, et issu du procédé de fabrication selon l'une quelconque des paragraphes précédents.

Selon un autre aspect, l'invention concerne un panneau photovoltaïque comprenant au moins un empilement de couches dans l'ordonnancement suivant :
- la couche translucide en polymère se présentant en avant du panneau,
- une couche de tissu sec en fibres de verre et une couche de tissu de fibre de verre pré-imprégné de résine époxy,
- la couche des cellules photovoltaïques,
- une seconde couche de tissu sec en fibres de verre et une seconde couche de tissu de fibre de verre pré-imprégné de résine époxy,
- la couche en arrière du panneau en polymère.

### 4. LISTE DES FIGURES

D'autres caractéristiques et avantages de l'invention apparaîtront à la lecture de la description suivante, donnée à titre d'exemple indicatif et non limitatif, et des dessins annexés, dans lesquels :
- la figure 1 présente un séquencement des étapes illustrant un procédé d'encapsulation de cellules photovoltaïques, selon un mode préféré de réalisation ;
- la figure 2 montre une connexion réalisée sur le prototype entre deux cellules photovoltaïques électriquement connectées par un transistor MOSFET ;
- la figure 3 présente un coté d'un panneau photovoltaïque en cours de réalisation, selon un exemple de réalisation ;
- la figure 4 représente un exemple de schéma montrant la succession de couches à réaliser avant l'étape de cuisson ;
- la figure 5 illustre la variation de température en fonction du temps pour la cuisson des couches selon un exemple de réalisation ;
- la figure 6 montre un schéma d'un appareil de lamination permettant la cuisson et la mise en pression de couches de matériaux, appelé « laminât ».

### 5. DESCRIPTION DÉTAILLÉE

Sur toutes les figures du présent document, les éléments (ou les étapes) identiques sont désignées par une même référence numérique.

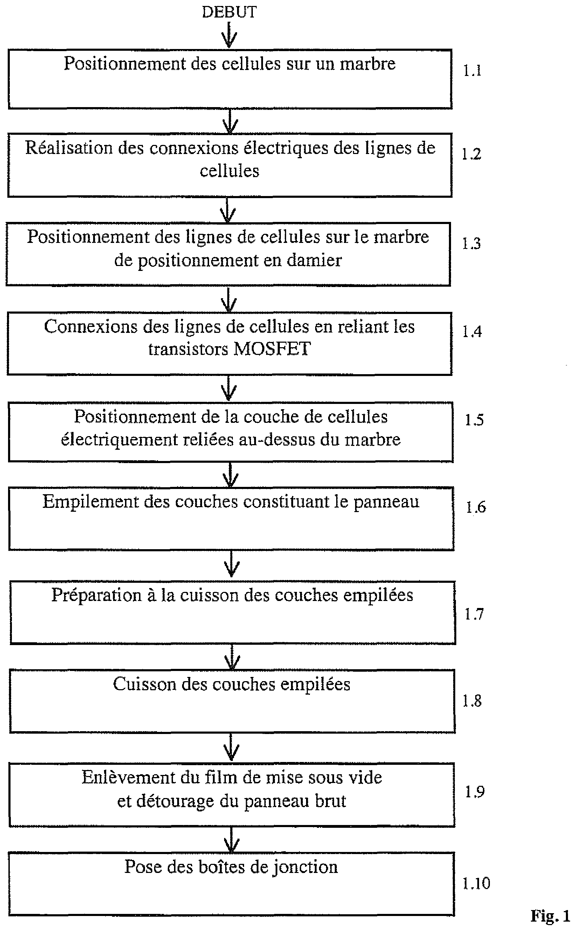

On présente maintenant, en relation avec la Fig. 1, un séquencement des étapes illustrant un procédé d'encapsulation de cellules photovoltaïques utilisant des matériaux composites et polymères, selon un mode préféré de réalisation de l'invention.

Les panneaux solaires comportent des cellules photovoltaïques qu'il est nécessaire d'assembler et de connecter électriquement les unes aux autres. Ces cellules photovoltaïques peuvent être du type « front contact » ce qui signifie que les connexions électriques s'effectuent sur la face avant (une polarité) et arrière (l'autre polarité) de la cellule ou du type « back contact », ce qui signifie que la connexion électrique s'effectue sur la face arrière de la cellule.

Selon un mode préféré, la cellule utilisée est du type SUNPOWER monocristalline. La cellule utilisée peut également être du type polycristalline. Cette cellule qui possède un excellent rendement est du type « back contact ». De par leur finesse et leur grande fragilité, les cellules photovoltaïques ne doivent pas être manipulées à la main. Des outils de préhension ont été développés pour le déplacement des cellules, ils comportent des ventouses, la cellule est maintenue au bout des outils par un vide d'air réalisé dans la ventouse. On trouve notamment un outil manuel pour le maniement d'une seule cellule, ou une tringle supportant une série de ventouses fixées en ligne, ou encore un cadre géométrique supportant des ventouses formant un damier.

Selon une première étape 1.1, les cellules sont placées avec l'outil manuel sur un support tel qu'un marbre de positionnement, fabriqué en aluminium et de dimensions 1700 millimètres par 1000 millimètres par exemple. Dans le prototype réalisé pour la fabrication des panneaux, on utilise au moins deux modèles de marbres de positionnement : un marbre en ligne pour assembler linéairement un nombre déterminé de cellules (6 par exemple), et un marbre en damier pour assembler un panneau entier de cellules (12 lignes de 6 cellules par exemple). Des empreintes sur le dessus du marbre coïncident parfaitement aux dimensions extérieures des cellules, avec un jeu de 0,2 millimètres en largeur et en longueur. Des dépouilles sont réalisées dans le profil d'usinage du marbre pour éviter la casse de cellule lors du soulèvement par l'outil de préhension.

Lorsque les cellules sont placées sur le marbre de positionnement en ligne en respectant leurs polarités, les connexions électriques sont réalisées (étape 1.2). Des bandes conductrices, appelées « tabs », sont pré-étamées, puis positionnées sur le bord des cellules. Des poids (ou «gueuses») permettent de maintenir les bandes et les cellules. A l'aide du brasage à 380°C, le pré-étamage et le flux permettent un bon mouillage de la cellule et de la bande par un alliage étain-plomb. D'autres bandes conductrices, appelées par la suite « strips de sortie » sont assemblées aux extrémités. A l'étape 1.3, chaque ligne de cellules électriquement connectées est déplacée à l'aide d'un outil de préhension, et positionnée sur le marbre d'assemblage en damier. A ce stade, il peut être utile de vérifier la conduction électrique des lignes de cellules. Pour cela, les cellules sont éclairées et un opérateur vérifie la tension en circuit ouvert aux bornes des cellules aux extrémités des lignes.

Les lignes de cellules vont maintenant être connectées électriquement les unes aux autres à travers des composants de dérivation de type « By-Pass ». Dans les panneaux sur le marché à la date du dépôt, ces composants sont de simples diodes. Ces diodes ont une fonction de sécurité et ne servent qu'en cas d'ombrage partiel du panneau. Elles permettent alors de dériver le courant et d'éviter le phénomène de point chaud (en Anglais « hotspot »). Ces diodes sont généralement placées dans les boîtes de jonction, qui doivent alors disposer d'un volume suffisamment important pour assurer la dissipation thermique. Pour réduire l'encombrement des boites de jonction, le procédé décrite dans la présente demande prévoit d'utiliser des transistors à effet de champ à grille isolée, plus couramment nommé MOSFET (acronyme anglais de Metal Oxide Semiconductor Field Effect Transistor - qui se traduit par transistor à effet de champ à structure métal-oxyde-semiconducteur). Pour les prototypes réalisés et testés, le composant SPV1001 de ST MICROELECTRONICS (de dimensions 5 mm x 6 mm, épaisseur 0.9 mm) a été utilisé, puis le composant SPV1520 du même constructeur. Il va de soi que ces références ne sont données qu'à titre d'exemple. Selon une variante de réalisation, les transistors MOSFET sont remplacés par des diodes standards. En utilisant de tels composants, les dissipations sont limitées et permettent une encapsulation directe dans les matériaux composites.

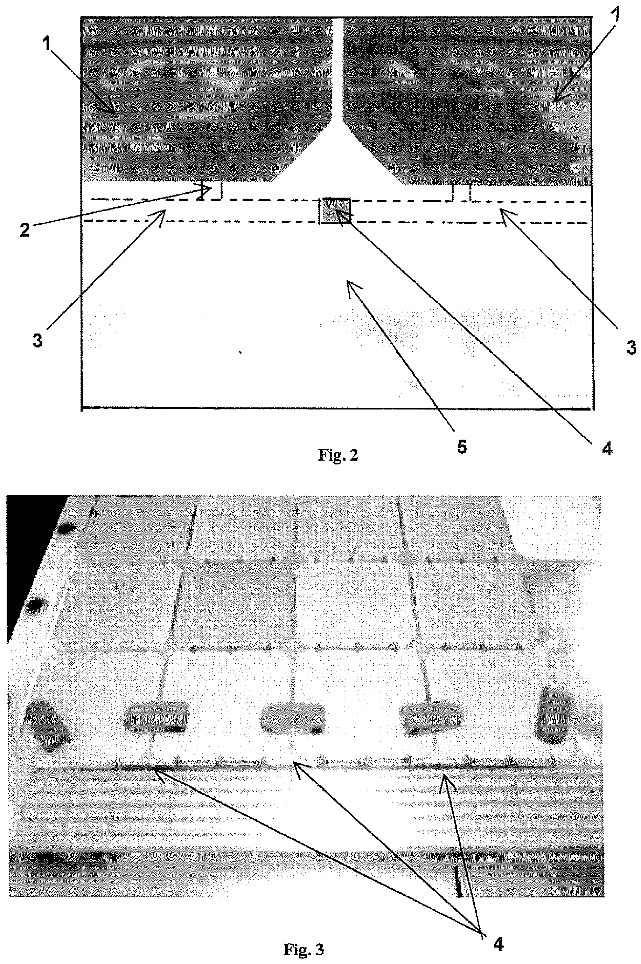

Une bande collectrice de sortie constituée d'une portion de ruban en cuivre est disposée le long de chaque cellule terminant une ligne. Les bandes ont approximativement la même longueur que le coté des cellules, laissant entre chaque bande un espace de 2 millimètres. A l'étape 1.4, un opérateur place un transistor MOSFET sur cet espace et le soude aux deux extrémités de la bande se faisant face de chaque coté de cet espace. La Fig. 2 montre une connexion réalisée, on y voit deux cellules photovoltaïques 1, des strips de sorties 2 connectant les cellules à la bande collectrice de sortie 3 et le transistor 4 MOSFET assurant la connexion entre les deux bandes. L'opérateur prend un soin tout particulier à respecter la polarité du composant. Sur cette figure, on voit également le marbre 5 sur lequel les cellules sont posées.

La Fig. 3 présente un coté d'un panneau en cours de réalisation, montrant 4 lignes dont les cellules à une extrémité sont raccordées par trois strips à une bande collectrice. Des transistors MOSFET 4 sont visibles sur les bandes collectrices au point d'intersection avec une droite passant le long des cotés longitudinaux des lignes de cellules. Une fois le circuit électrique réalisé, l'assemblage de cellules est entouré par dessous et par dessus de couches protectrices. A l'étape 1.5, la couche formée de l'ensemble des cellules est déplacée au-dessus d'un marbre d'encapsulation à l'aide de l'outil de préhension composé de ventouses formant un damier. Ce marbre a été préalablement recouvert d'une couche de cire, de type CIREX S 1 042.

Le procédé de fabrication comporte l'application de couches en matériaux composites et polymères selon un séquencement précis. Les matériaux composites assurent l'encapsulation des cellules et des strips. Ils se présentent sous la forme de tissus de fibres de verre, imprégnés de résine époxy ou secs. Une fois les couches de tissu reliées de manière homogène et irréversible par la résine réticulée, la cellule photovoltaïque se retrouve solidement emprisonnée entre deux couches de matériaux composites, la cellule est alors encapsulée.

Voici des exemples de couches Ci successivement appliquées sur le marbre d'encapsulation au cours d'une étape d'empilement 1.6, et préalablement à l'étape de cuisson :
- C1 : couche translucide en avant du panneau (en Anglais « Frontsheet »), c'est un film de surface supérieure pour l'étanchéité et la protection contre les UV responsables du jaunissement de la résine époxyde. Le film référencé TEDLAR TUT 10BG3 0,025MM est utilisé pour le prototype. Cette couche en avant du panneau est de préférence en polymère, et peut être appliquée sous forme solide (un film plastique s'étendant sur la surface du panneau), ou par voie liquide qui se solidifie au moment de la cuisson.
- C2 : c'est une couche de tissu sec, de la fibre de verre par exemple. Le film référencé RE 70P, modèle PLAIN EGL : 70gr/m2, laize 1000mm, fourni par la société Hexcel est utilisé pour le prototype.
- C3 : c'est une couche de tissu de verre, pré-imprégnée de résine époxy, typiquement 200 gr/m². Le film référencé WT93/RE200P/1270/60%/S/S, est utilisé pour le prototype.
- C4 : c'est la couche des cellules photovoltaïques, connectées par des strips et dotées de transistors MOSFET. Les cellules peuvent du type « Front Contact », ou du type « Back Contact ». La présente demande concerne tout type de cellules photovoltaïques produisant de l'électricité.
- C5 : c'est de nouveau une couche de tissu sec, de la fibre de verre par exemple (RE 70P).
- C6 : c'est de nouveau une couche de tissu de verre, pré-imprégnée de résine époxy, typiquement 200 gr/m², de même référence : WT93/RE200P/1270/60%/S/S.
- C7 : c'est la couche en arrière du panneau (en Anglais « Backsheet »), c'est un film de surface permettant l'étanchéité et servant de barrière UV, en polymère, de préférence opaque mais qui peut aussi être translucide. Le film référencé TPM 125 BLANC BTPMWH0262RDER, coloré blanc est utilisé pour le prototype. Cette couche en arrière du panneau est de préférence en polymère, et peut être appliquée sous forme solide (un film plastique s'étendant sur la surface du panneau), ou par voie liquide qui se solidifie au moment de la cuisson, en conservant des propriétés élastiques.

Selon un mode préféré de réalisation, les couches de tissu sec et de tissu pré-imprégné de résine sont situées de chaque coté de la couche des cellules photovoltaïques. Selon un mode simplifié de réalisation, les couches de tissu sec et de tissu pré-imprégné de résine sont situées uniquement devant, les couches en arrière peuvent être fabriquées avec un autre matériau, du lin ou du chanvre par exemple.

Selon un mode préféré de réalisation, la couche de tissu sec et la couche de tissu pré-imprégné de résine sont en contact avant la cuisson. Selon un mode simplifié de réalisation, la couche de tissu pré-imprégné de résine suffit pour assurer le collage après la cuisson.

Le marbre d'encapsulation permet de transmettre son état de surface sur la couche de polymère en « frontsheet », sa surface est donc lisse et sans aspérités et présente un bel aspect. Les couches C1, C2, C3, C5, C6 et C7 sont découpées à la même dimension, qui est relativement plus grande en largeur et en longueur que celle de la couche (C4) des cellules photovoltaïques. Le fait qu'au moins les couches (C2, C5) de tissu sec soient de dimensions plus grandes que celles d'au moins la couche des cellules photovoltaïques (C4) améliore notamment l'extraction des gaz par les coté de l'empilement au cours de la cuisson. Cette inégalité des dimensions entre les couches nécessite un détourage à la fin du procédé.

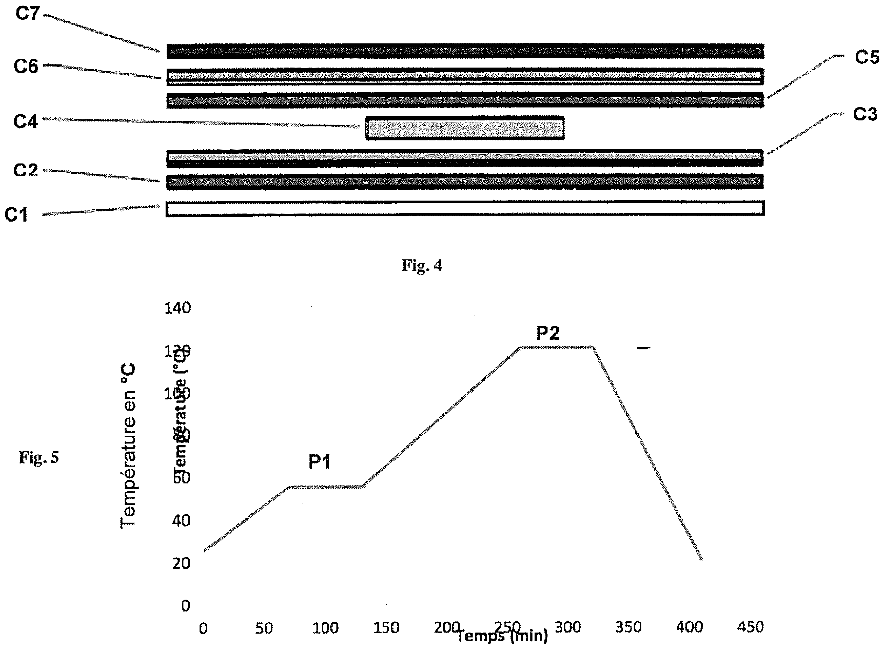

La Fig. 4 représente un schéma montrant la succession de couches à réaliser avant la cuisson de l'empilement. Les couches C1 à C7 sont superposées de préférence dans l'ordre précis listé ci-dessus, et constitue le panneau une fois encapsulé par la résine époxy. Ce panneau possède typiquement une épaisseur de 0,9 millimètres pour un poids de 1600g/m².

Après l'étape 1.6 d'empilement des couches, l'opérateur effectue une étape de préparation (étape 1.7) à l'encapsulation en utilisant des couches de produit consommables. Les sept couches C1 à C7, sont recouvertes d'abord d'un tissu d'arrachage, lui même recouvert d'un film séparateur. Enfin, le tout est recouvert d'un feutre de drainage permettant d'extraire l'air du pompage. L'étape de préparation 1.7 comporte le découpage des trois couches de produits consommables. L'étape de préparation 1.7 se termine par l'apposition d'un film de mise sous vide, et l'application d'un mastic d'étanchéité tout autour de ce film.

L'étape de cuisson 1.8 commence par l'extraction de l'air sous le film de façon à créer un vide pour éliminer l'air qui serait nuisible à l'encapsulation et permettre au film d'exercer une pression sur l'ensemble des couches et de les plaquer contre le marbre d'encapsulation. Les couches de tissu sec permettent dans un premier temps de drainer l'air et dans un second temps d'aspirer les gaz produits par le chauffage la résine époxy imprégnant les autres tissus. De cette manière, au cours de l'étape de cuisson, la quasi totalité des gaz sont chassés de l'empilement à l'extérieur de l'empilement par une pompe à vide. La mise en chaleur intervient lors que le vide atteint une pression de -0,9 bar. Le drainage de l'air doit durer minimum 60 minutes avant la mise en cuisson.

Un appareil de régulation de température régule précisément le cycle de cuisson des différents matériaux composants l'empilement. Le cycle de température est constitué de deux paliers. Le premier, à 55°C environ, sert à compacter et drainer l'air libéré lors du ramollissement de la résine (abaissement de la viscosité). Le deuxième, à 120° environ, est nécessaire pour obtenir un taux d'avancement de la réaction chimique proche de 100%.

La Fig. 5 représente la variation de température en fonction du temps permettant la cuisson optimale des couches selon un exemple de réalisation. Selon l'exemple illustré, le cycle de cuisson dure 400 minutes. Une fois le cycle terminé, la température descend progressivement et il est conseillé d'ouvrir légèrement les portes du four pendant une durée minimale, par exemple 30 minutes, avant la manipulation de la table d'encapsulation et le débâchage du panneau brut.

Une fois la cuisson terminée, l'opérateur effectue une étape de finition (étape 1.9). Au début de cette étape, l'opérateur retire le film de mise sous vide, le feutre de drainage, le séparateur et le tissu d'arrachage. Le panneau photovoltaïque brut de moulage apparaît et sa rigidité permet de facilement le manipuler. L'opérateur détoure le panneau à l'aide d'un ciseau pour donner la même dimension à chaque couche encapsulée. En variante, cette opération peut être automatisée, à l'aide d'un robot muni d'un outil de découpe. Une fois le panneau détouré, un vernis de protection est déposé sur les chants du panneau.

A l'étape 1.10, des connecteurs sont posés. Chaque connecteur permet une liaison étanche et solide entre les cellules du panneau et les câbles de connexion vers l'onduleur. Le connecteur se présente comme une petite boîte de préférence collée sur la surface du panneau et remplie de matière injectable. La connexion s'effectue de façon simple par deux rubans de cuivre émergeant du composite. A l'intérieur du connecteur, ces rubans sont connectés par brasage sur le contact interne provenant des cellules. Afin d'assurer une parfaite étanchéité, les connecteurs sont remplis d'une résine époxy d'enrobage silicone et le couvercle est refermé. Il est possible à ce stade de réaliser un test de continuité électrique en polarisant le panneau en inverse sur une alimentation limitée en courant.

A l'issue des étapes du procédé, le panneau photovoltaïque ainsi réalisé possède une légèreté (1,600 kg/m²) bien supérieure à celle des panneaux mis sur le marché au moment du dépôt de la présente demande. De plus, un tel panneau présente une flexibilité accrue. En effet, le panneau résiste à une courbure d'un rayon de 200 millimètres, permettant ainsi de l'installer sur des surfaces courbes et de pouvoir les rouler pour le transport. Le panneau ainsi réalisé possède également un bon rendement, une excellente fiabilité, validée lors de la certification, et un faible coût d'industrialisation.

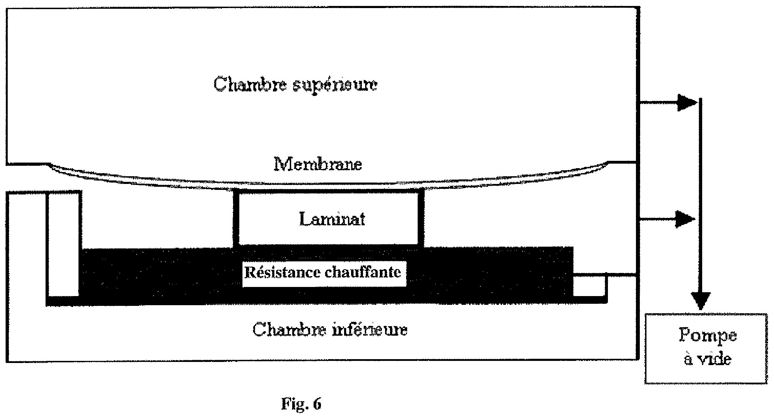

Selon une variante de réalisation, la cuisson s'effectue dans un appareil appelé laminateur qui est schématiquement illustré par la Fig. 6. Cet appareil permet à la fois de chauffer les couches et de les maintenir en pression. Le laminateur dispose d'une chambre supérieure et d'une chambre inférieure. La température et la pression de chacune de ces chambres sont contrôlées grâce à la pompe à vide et des résistances chauffantes. L'empilement des couches de matériaux constituant le panneau photovoltaïque, appelé « laminât », se positionne dans le laminateur entre les deux chambres.

Le cycle de lamination débute par l'introduction de l'ensemble constitué de cellules et des matériaux encapsulants (composite), dans la chambre inférieure du laminateur où la température est maintenue constante à 120 °C. La chambre supérieure, dont la membrane du bas, est à ce moment là sous dépression de - 0.9 bar, soit quasiment sous vide. La lamination se fait en deux temps. Dans une première phase, on procède au pompage de l'air se trouvant à l'intérieur de la chambre inférieure contenant le laminât, et ce durant 3 minutes. Le niveau du vide atteint est alors de -0.9 bar, il sera maintenu durant les opérations de lamination et de polymérisation. Dans une deuxième phase, alors que la chambre supérieure maintenue sous vide à - 0.9 bar durant ces 3 premières minutes, elle sera mise sous pression atmosphérique en 1 minute de temps et jusqu'à polymérisation complète (1h à 120°).

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration mais peuvent être modifiés dans le domaine défini par la portée des revendications jointes.

## Revendications

1. Procédé de fabrication d'un panneau de cellules photovoltaïques, comportant une étape de cuisson (1.8) d'un empilement d'une pluralité de couches comprenant des matériaux différents, et une étape d'empilement (1.6) comportant la mise en place des couches suivantes :
- une couche avant translucide (C1).
- au moins deux couches (C2, C5) de tissu sec de fibres de verre,
- au moins deux couches (C3, C6) de tissu de fibres de verre pré-imprégné de résine époxy,
- une couche de cellules photovoltaïques (C4),
- une couche arrière (C7),
**caractérisé en ce que** la couche avant translucide (C1) et la couche de cellules photovoltaïques sont séparées par une couche (C2, C5) de tissu sec de fibres de verre et une couche (C3, C6) de tissu de fibres de verre pré-imprégné de résine époxy, et que la couche de cellules photovoltaïques (C4) et la couche arrière sont également séparées par une couche (C2, C5) de tissu sec de fibres de verre et une couche (C3, C6) de tissu de fibres de verre pré-imprégné de résine époxy.

2. Procédé de fabrication d'un panneau de cellules photovoltaïques selon la revendication 1, **caractérisé en ce que** l'empilement consiste à empiler les couches ci-dessous dans cet ordre :
- la couche translucide (C1) se présentant en avant du panneau,
- une couche de tissu sec (C2) en fibres de verre,
- une couche de tissu de fibre de verre (C3) pré-imprégné de résine époxy,
- la couche des cellules photovoltaïques (C4),
- une seconde couche de tissu sec (C5) en fibres de verre,
- une seconde couche de tissu de fibre de verre (C6) pré-imprégné de résine époxy,
- la couche en arrière du panneau (C7).

3. Procédé de fabrication d'un panneau de cellules photovoltaïques selon la revendication 2, **caractérisé en ce que** la couche translucide en avant du panneau et empilée en premier se trouve au contact d'un support tel qu'un marbre d'encapsulation sur laquelle s'effectue l'étape de cuisson.

4. Procédé de fabrication d'un panneau de cellules photovoltaïques selon l'une quelconque des revendications précédentes, **caractérisé en ce que** l'étape de cuisson commence par une étape préalable de mise sous vide de l'empilement.

5. Procédé de fabrication d'un panneau de cellules photovoltaïques selon la revendication 4, **caractérisé en ce que** l'étape préalable de mise sous vide de l'empilement s'effectue en appliquant un film de mise sous vide sur l'empilement et en aspirant l'air sous le film à l'aide d'une pompe à vide.

6. Procédé de fabrication d'un panneau de cellules photovoltaïques selon l'une quelconque des revendications précédentes, **caractérisé en ce que** l'étape d'empilement des couches consiste à appliquer des couches (C2, C3, C5, C6) de tissu sec de dimensions plus grandes que celles d'au moins la couche des cellules photovoltaïques (C4), et **en ce qu'**il comporte une étape de finition (1.9) consistant notamment à détourer le panneau ainsi réalisé.

7. Procédé de fabrication d'un panneau de cellules photovoltaïques selon l'une quelconque des revendications précédentes, **caractérisé en ce que** l'étape de cuisson (1.7) consiste successivement à maintenir un premier niveau de température pendant une durée déterminée et un second niveau de température dont la valeur est supérieure à la première pendant une seconde durée déterminée, et à maintenir l'empilement sans le bouger après cuisson pendant une troisième durée déterminée.

8. Procédé de fabrication d'un panneau de cellules photovoltaïques selon l'une quelconque des revendications précédentes, **caractérisé en ce que** la cuisson sous vide de l'empilement s'effectue dans un laminateur.

9. Procédé de fabrication d'un panneau de cellules photovoltaïques selon l'une quelconque des revendications précédentes, **caractérisé en ce que**, préalablement à l'étape d'empilement (1.6) des couches, le procédé comporte une étape de réalisation (1 .3, 1.4) de la couche de cellules photovoltaïques comportant la connexion de lignes de cellules mises en série, les dites lignes étant connectées entre elles par des transistors à effet de champ encapsulés dans le panneau à l'issue de l'étape de cuisson.

10. Procédé de fabrication d'un panneau de cellules photovoltaïques selon la revendication 9, **caractérisé en ce qu'**il comporte une étape de mise en place de connecteurs électriquement reliés à des lignes collectrices d'électricité reliées aux cellules et sortant de l'empilement, les connecteurs étant capotés par des boîtiers remplis de silicone.

11. Procédé de fabrication d'un panneau de cellules photovoltaïques selon l'une quelconque des revendications précédentes, **caractérisé en ce que** la couche arrière est opaque.

12. Panneau photovoltaïque comprenant au moins un empilement de couches dans l'ordonnancement suivant :
- la couche translucide (C1) se présentant en avant du panneau,
- une couche de tissu sec (C2) en fibres de verre et une couche de tissu de fibre de verre (C3) pré-imprégné de résine époxy,
- la couche des cellules photovoltaïques (C4),
- une seconde couche de tissu sec (C5) en fibres de verre et une seconde couche de tissu de fibre de verre (C6) pré-imprégné de résine époxy,
- la couche en arrière du panneau (C7).

13. Panneau photovoltaïque selon la revendication 12, **caractérisé en ce que** la couche avant est fabriquée en polymères.

14. Panneau photovoltaïque selon la revendication 12 ou 13, **caractérisé en ce que** la couche arrière est fabriquée en polymères.

## Patentansprüche

1. Verfahren zum Herstellen eines Solarzellenpanels, umfassend einen Schritt des Brennens (1.8) eines Stapels aus mehreren Schichten umfassend verschiedene Materialien, und einen Schritt des Stapelns (1.6), der das Anordnen der folgenden Schichten aufweist:
- einer lichtdurchlässigen vorderen Schicht (C1),
- mindestens zwei Schichten (C2, C5) aus trockenem Glasfasergewebe,
- mindestens zwei Schichten (C3, C6) aus Glasfasergewebe, das mit Epoxyharz vorimprägniert ist,
- einer Solarzellenschicht (C4),
- einer hinteren Schicht (C7),
**dadurch gekennzeichnet, dass** die lichtdurchlässige vordere Schicht (C1) und die Solarzellenschicht durch eine Schicht (C2, C5) aus trockenem Glasfasergewebe und eine Schicht (C3, C6) aus Glasfasergewebe, das mit Epoxyharz vorimprägniert ist, getrennt sind, und dass die Solarzellenschicht (C4) und die hintere Schicht ebenfalls durch eine Schicht (C2, C5) aus trockenem Glasfasergewebe und eine Schicht (C3, C6) aus Glasfasergewebe, das mit Epoxyharz vorimprägniert ist, getrennt sind.

2. Verfahren zum Herstellen eines Solarzellenpanels nach Anspruch 1, **dadurch gekennzeichnet, dass** das Stapeln darin besteht, die nachfolgenden Schichten in dieser Reihenfolge zu stapeln:
- die lichtdurchlässige Schicht (C1), die sich auf der Vorderseite des Panels befindet,
- eine Schicht (C2) aus trockenem Glasfasergewebe,
- eine Schicht (C3) aus Glasfasergewebe, das mit Epoxyharz vorimprägniert ist,
- die Solarzellenschicht (C4),
- eine zweite Schicht (C5) aus trockenem Glasfasergewebe,
- eine zweite Schicht (C6) aus Glasfasergewebe, das mit Epoxyharz vorimprägniert ist,
- die Schicht auf der Rückseite des Panels (C7).

3. Verfahren zum Herstellen eines Solarzellenpanels nach Anspruch 2, **dadurch gekennzeichnet, dass** die lichtdurchlässige Schicht auf der Vorderseite des Panels, die zuerst gestapelt wird, in Kontakt mit einem Träger steht, etwa einem Marmor, zum Einkapseln, auf dem der Schritt des Brennens durchgeführt wird.

4. Verfahren zum Herstellen eines Solarzellenpanels nach einem der vorhergehenden Ansprüche, **dadurch gekennzeichnet, dass** der Schritt des Brennens mit einem vorhergehenden Schritt des Vakuumierens des Stapels beginnt.

5. Verfahren zum Herstellen eines Solarzellenpanels nach Anspruch 4, **dadurch gekennzeichnet, dass** der vorhergehende Schritt des Vakuumierens des Stapels durchgeführt wird, indem eine Vakuumierfolie auf den Stapel aufgebracht wird und indem die Luft unter der Folie mit Hilfe von einer Vakuumpumpe abgesaugt wird.

6. Verfahren zum Herstellen eines Solarzellenpanels nach einem der vorhergehenden Ansprüche, **dadurch gekennzeichnet, dass** der Schritt des Stapelns darin besteht, Schichten (C2, C3, C5, C6) aus trockenem Gewebe von Abmessungen, die größer sind als jene von mindestens der Solarzellenschicht (C4), aufzubringen, und dadurch, dass es einen Endbearbeitungsschritt (1.9) aufweist, der insbesondere darin besteht, das auf diese Weise erstellte Panel auszuschneiden.

7. Verfahren zum Herstellen eines Solarzellenpanels nach einem der vorhergehenden Ansprüche, **dadurch gekennzeichnet, dass** der Schritt des Brennens (1.7) darin besteht, nacheinander ein erstes Temperaturniveau während einer vorbestimmten Zeitdauer und ein zweites Temperaturniveau, dessen Wert höher als der erste ist, während einer zweiten vorbestimmten Zeitdauer aufrecht zu erhalten, und den Stapel nach dem Brennen während einer dritten vorbestimmten Zeitdauer zu halten, ohne ihn zu bewegen.

8. Verfahren zum Herstellen eines Solarzellenpanels nach einem der vorhergehenden Ansprüche, **dadurch gekennzeichnet, dass** das Vakuumbrennen des Stapels in einem Laminator durchgeführt wird.

9. Verfahren zum Herstellen eines Solarzellenpanels nach einem der vorhergehenden Ansprüche, **dadurch gekennzeichnet, dass** das Verfahren vor dem Schritt des Stapelns (1.6) der Schichten einen Schritt des Erstellens (1.3, 1.4) der Solarzellenschicht aufweist, umfassend das Verbinden von Zeilen von Zellen, die in Reihe geschaltet werden, wobei die Zeilen durch Feldeffekttransistoren miteinander verbunden werden, die in dem Panel am Ende des Schrittes des Brennens eingekapselt werden.

10. Verfahren zum Herstellen eines Solarzellenpanels nach Anspruch 9, **dadurch gekennzeichnet, dass** es einen Schritt des Anordnens von Steckverbindern aufweist, die an Stromsammelleitungen, die an den Zellen angeschlossen werden, elektrisch angeschlossen werden und aus dem Stapel treten, wobei die Steckverbinder von Gehäusen abgedeckt werden, die mit Silikon gefüllt werden.

11. Verfahren zum Herstellen eines Solarzellenpanels nach einem der vorhergehenden Ansprüche, **dadurch gekennzeichnet, dass** die hintere Schicht lichtundurchlässig ist.

12. Solarpanel, umfassend mindestens einen Stapel von Schichten in der folgenden Anordnung:
- die lichtdurchlässige Schicht (C1), die sich auf der Vorderseite des Panels befindet,
- eine Schicht aus trockenem Glasfasergewebe (C2) und eine Schicht aus Glasfasergewebe (C3), das mit Epoxyharz vorimprägniert ist,
- die Solarzellenschicht (C4),
- eine zweite Schicht aus trockenem Glasfasergewebe (C5) und eine zweite Schicht aus Glasfasergewebe (C6), das mit Epoxyharz vorimprägniert ist,
- die Schicht auf der Rückseite des Panels (C7).

13. Solarpanel nach Anspruch 12, **dadurch gekennzeichnet, dass** die vordere Schicht aus Polymeren hergestellt ist.

14. Solarpanel nach Anspruch 12 oder 13, **dadurch gekennzeichnet, dass** die hintere Schicht aus Polymeren hergestellt ist.

## Claims

1. Method for producing a panel of photovoltaic cells, comprising a step (1.8) for baking a stack of a plurality of layers comprising different materials, and a stacking step (1.6) comprising positioning of the following layers:
- a translucent front layer (C1),
- at least two layers (C2, C5) of dry glass fibre fabric,
- at least two layers (C3, C6) of glass fibre fabric pre-impregnated with epoxy resin,
- a layer of photovoltaic cells (C4),
- a rear layer (C7),
**characterised in that** the translucent front layer (C1) and the layer of photovoltaic cells are separated by a layer (C2, C5) of dry glass fibre fabric and a layer (C3, C6) of glass fibre fabric pre-impregnated with epoxy resin and **in that** the layer of photovoltaic cells (C4) and the rear layer are also separated by a layer (C2, C5) of dry glass fibre fabric and a layer (C3, C6) of glass fibre fabric pre-impregnated with epoxy resin.

2. Method for producing a panel of photovoltaic cells according to claim 1, **characterised in that** the stacking consisting in stacking the layers below in this order:
- the translucent layer (C1) being at the front of the panel,
- a layer (C2) of dry glass fibre fabric,
- a layer (C3) of glass fibre fabric pre-impregnated with epoxy resin,
- the layer of photovoltaic cells (C4),
- a second layer (C5) of dry glass fibre fabric,
- a second layer (C6) of glass fibre fabric pre-impregnated with epoxy resin,
- the layer at the rear of the panel (C7).

3. Method for producing a panel of photovoltaic cells according to claim 2, **characterised in that** the translucent layer at the front of the panel and stacked first is in contact with a support such as an encapsulating marble on which the baking step is carried out.

4. Method for producing a panel of photovoltaic cells according to any one of the preceding claims, **characterised in that** the baking step begins with a prior step of placing the stack under reduced pressure.

5. Method for producing a panel of photovoltaic cells according to claim 4, **characterised in that** the prior step of placing the stack under reduced pressure is carried out by applying a vacuum bagging film to the stack and drawing off the air below the film using a vacuum pump.

6. Method for producing a panel of photovoltaic cells according to any one of the preceding claims, **characterised in that** the step of stacking the layers involves applying layers (C2, C3, C5, C6) of dry fabric with larger dimensions than those of at least the layer (C4) of photovoltaic cells and **in that** it comprises a finishing step (1.9) consisting in particular cutting out the panel thus produced.

7. Method for producing a panel of photovoltaic cells according to any one of the preceding claims, **characterised in that** the baking step (1.7) consists in successively maintaining a first temperature level for a predetermined period of time and a second temperature level whose value is greater than the first for a second predetermined period of time, and maintaining the stack without moving it after baking for a third predetermined period of time.

8. Method for producing a panel of photovoltaic cells according to any one of the preceding claims, **characterised in that** the baking of the stack under reduced pressure is carried out in a laminator.

9. Method for producing a panel of photovoltaic cells according to any one of the preceding claims, **characterised in that**, prior to the step (1.6) of stacking the layers, the method comprises a step (1.3, 1.4) of producing the layer of photovoltaic cells comprising the connection of lines of cells placed in series, the lines being connected to each other by field-effect transistors which are encapsulated in the panel at the end of the baking step.

10. Method for producing a panel of photovoltaic cells according to claim 9, **characterised in that** it comprises a step of positioning connectors which are electrically connected to electricity collection lines which are connected to the cells and which leave the stack, the connectors being covered by casings filled with silicone.

11. Method for producing a panel of photovoltaic cells according to any one of the preceding claims, **characterised in that** the rear layer is opaque.

12. Photovoltaic cell comprising at least one stack of layers in the following order:
- the translucent layer (C1) being at the front of the panel,
- a layer (C2) of dry glass fibre fabric and a layer (C3) of glass fibre fabric pre-impregnated with epoxy resin,
- the layer of photovoltaic cells (C4),
- a second layer (C5) of dry glass fibre fabric and a second layer (C6) of glass fibre fabric pre-impregnated with epoxy resin,
- the layer at the rear of the panel (C7).

13. Photovoltaic panel according to claim 12, **characterised in that** the front layer is produced from polymers.

14. Photovoltaic panel according to claim 12 or 13, **characterised in that** the rear layer is produced from polymers.
